# EUROPÄISCHE PATENTSCHRIFT

(11) **EP 0 833 206 B1**
(45) Veröffentlichungstag und Bekanntmachung des Hinweises auf die Patenterteilung: **18.12.2002**
(21) Anmeldenummer: 97116603.8
(22) Anmeldetag: 24.09.1997
(51) Int. Cl.: G03F 7/033

(54) **Photopolymerisierbares Gemisch zur Herstellung von flexographischen Druckformen mit verbesserter Beständigkeit gegenüber UV härtbaren Druckformen**
Photopolymerizable composition for the production of flexographic printing forms with improved resistance to UV-hardenable printing inks
Composition photopolymerisable pour la production des clichés flexographiques avec de la résistance améliorée vers des encres d'imprimerie solidifiable par UV

(30) Priorität: 27.09.1996 DE 19639761
(43) Veröffentlichungstag der Anmeldung: 01.04.1998
(73) Patentinhaber: DU PONT DE NEMOURS (DEUTSCHLAND) GMBH, 61343 Bad Homburg v.d.H. (DE); E.I. DU PONT DE NEMOURS AND COMPANY, Wilmington Delaware 19898 (US)
(72) Erfinder: Dudek, Dietmar, Dr., 63225 Langen (DE); Hinz, Konrad, 63303 Dreieich (DE); Struck, Bernd, 63303 Dreieich (DE)

(56) Entgegenhaltungen:
- EP-A- 0 027 612
- EP-A- 0 437 068
- EP-A- 0 438 967
- EP-A- 0 653 464
- EP-B- 0 362 850
- US-A- 4 162 919
- US-A- 4 430 417
- US-A- 4 913 991
- US-A- 5 239 009
- US-A- 5 281 510
- PATENT ABSTRACTS OF JAPAN vol. 16, no. 114 (C-0921), 23. März 1992 & JP 03 287652 A (KURARAY CO., LT.), 18. Dezember 1991
- PATENT ABSTRACTS OF JAPAN vol. 95, no. 1, 28. Februar 1995 & JP 06 293853 A (KURARAY CO., LTD.), 21. Oktober 1994
- DATABASE WPI Section Ch, Week 9503 Derwent Publications Ltd., London, GB; Class A10, AN 95-019299 XP002089165 & JP 06 306128 A (KURARAY CO., LTD.) , 1. November 1994

## Beschreibung

Die Erfindung betrifft ein photopolymerisierbares Gemisch enthaltend elastomere Bindemittel, photopolymerisierbare, ethylenisch ungesättigte Verbindungen und Photoinitiatoren, eine photopolymerisierbare Druckplatte umfassend mindestens eine photopolymerisierbare Schicht aus solch einem Gemisch und eine daraus hergestellte flexographische Druckform.

Es ist bekannt, für die Herstellung von flexographischen Druckformen photopolymerisierbare Druckplatten zu verwenden, bei denen die Druckoberfläche durch bildmäßiges Belichten einer durch aktinische Strahlung photopolymerisierbaren Schicht und anschließendes Entfernen der unbelichteten, nicht photopolymerisierten Druckplattenbereiche erzeugt wird. Beispiele hierfür finden sich in den folgenden Patenten: DE-C 22 15 090, US-A 4,266,005; US-A 4,320,188; US-A 4,126,466 und US-A 4,430,417.

Solche photopolymerisierbaren Druckplatten setzen sich üblicherweise aus einem Schichtträger, ggf. einer Haft- oder anderen Unterschicht, einer oder mehreren photopolymerisierbaren Schichten, ggf. einer elastomeren Zwischenschicht und einer Deckschicht zusammen.

Eine bevorzugte Methode zur Herstellung solcher mehrschichtigen, photopolymerisierbaren Druckplatten ist ein Verfahren, bei dem in den Spalt eines Kalanders eine vorher extrudierte, photopolymerisierbare Masse eingeführt und zwischen einen Träger und ein Deckelement kalandriert wird, wodurch eine photopolymerisierbare Schicht zwischen ihnen gebildet wird. Aus der EP-B 0 084 851 ist ein Herstellungsverfahren für eine mehrschichtige, photopolymerisierbare Druckplatte bekannt, die zwischen der flexiblen, reißfesten Polymerschicht und der photopolymerisierbaren Schicht eine weitere elastomere Schicht besitzt.

Die photopolymerisierbaren Schichten enthalten polymere Bindemittel, photopolymerisierbare Monomere, Photoinitiatoren und weitere Hilfsstoffe wie Weichmacher, Füllstoffe, Stabilisatoren, u.s.w. Als polymere Bindemittel werden üblicherweise thermoplastisch elastomere Blockcopolymere verwendet, wie sie in der DE-C 22 15 090 beschrieben sind. Dies sind im allgemeinen A-B-A Blockcopolymere mit thermoplastischen Blöcken A und elastomeren Blöcken B, insbesondere lineare und radiale Blockcopolymere mit Polystyrolendblöcken wie z.B. Polystyrol-Polyisopren-Polystyrol, (Polystyrol-Polyisopren)₄Si oder die entsprechenden Butadienpolymere. Für spezielle Anwendungen, wie z.B. für die Verbesserung der Eigenschaften von Druckplatten mit speziellen Monomeren (EP 0 525 206) oder zur Herstellung von Druckplatten ohne Monomerzusatz (EP-A 0 696 761), ist auch die Verwendung von Polymeren mit einem bestimmten Vinylbindungsgehalt bekannt. Ähnliche Blockcopolymere und deren Verwendung im Straßenbau und bei der Automobilherstellung sind in der EP-B 0 362 850 beschrieben. Für die Herstellung von flexographischen Druckformen werden jedoch bevorzugt Polystyrol-Polybutadien-Polystyrol- und Polystyrol-Polyisopren-Polystyrol-Blockcopolymere eingesetzt.

Häufig entsprechen jedoch die nach dem Stand der Technik hergestellten Druckformen nicht den in der Praxis im Flexodruck gestellten Anforderungen. Insbesondere bei der Verwendung von UV-härtbaren Druckfarben sind sie nicht genügend resistent gegenüber dem Eindiffundieren von Farbbestandteilen. Dies führt im Laufe des Drucks zu einer Schichtdickenzunahme, einer Veränderung der Bildgeometrie an der Druckformoberfläche und einer Abnahme der Shore A Härte. Dies wiederum äußert sich im Druckbild als unerwünschte Bildelementverbreiterung von positiven Bildelementen bzw. als Zulaufen von feinen negativen Bildelementen.

Der vorliegenden Erfindung lag daher die Aufgabe zugrunde, flexographische Druckformen mit verbesserter Resistenz gegenüber UV-härtbaren Druckfarben zur Verfügung zu stellen, die die beschriebenen Nachteile der Druckformen des Standes der Technik nicht aufweisen, und die photopoplymerisierbaren Druckplatten zur Herstellung dieser flexographischen Druckformen sollen einen erhöhten Belichtungsspielraum aufweisen, ohne daß andere wesentliche Eigenschaften der photopolymerisierbaren Druckplatten oder der flexographischen Druckforman negativ beeinflußt werden.

Diese Aufgabe wurde überraschenderweise gelöst durch ein photopolymerisierbares Gemisch und eine photopolymerisierbare Druckplatte enthaltend mindestens ein elastomeres Bindemittel, mindestens eine photopolymerisierbare, ethylenisch ungesättigte Verbindung, mindestens einen Photoinitiator oder ein Photoinitiatorsystem, dadurch gekennzeichnet, daß es 10 - 45 Gew.-% mindestens eines thermoplastisch elastomeren Blockcopolymers zusammengesetzt aus zwei oder mehreren Polymerblöcken, aufgebaut aus aromatischen Monomeren, und einem oder mehreren Polymerblöcken, aufgebaut aus Isoprenund/oder Isopren/Butadien- Einheiten, mit einem Vinylbindungsgehalt von höchstens 70%, mit einer Glasübergangstemperatur von höchstens 20°C und mit einer Peak-Temperatur einer primären Dispersion von tan a von höchstens 30°C, enthält, und eine hieraus hergestellte flexographische Druckform.

Überraschenderweise wird durch den Einsatz der erfindungsgemäßen Polymere die Beständigkeit von flexographischen Druckformen gegenüber UV-härtbaren Druckfarben wesentlich gesteigert.Außerdem wird auch der Belichtungsspielraum der photopolymerisierbaren Druckplatten deutlich erhöht, was wegen der speziellen Motivauswahl beim UV-Farbendruck sehr wichtig ist. Desweiteren zeigen die aus den erfindungsgemäßen Materialien hergestellten Druckformen eine gute Farbübertragung und eine gleichbleibende Shore A Härte.

Als erfindungswesentliche Blockcopolymere werden thermoplastisch elastomere Blockcopolymere verwendet, die zwei oder mehrere Blöcke aufgebaut aus aromatischen Monomeren und einen oder mehrere Blöcke aufgebaut aus Isopren- bzw. Isopren/Butadien-Einheiten enthalten. Bevorzugt werden Polystyrol- und Polyisopren-Blöcke verwendet.Insbesondere Polystyrol-Polyisopren-Polystyrol-Dreiblockcopolymere sind bevorzugt.

Der Vinylbindungsgehalt der erfindungsgemäßen Blockcopolymere beträgt höchstens 70%, bevorzugt 30 - 60%, und wird, wie in der EP-B 03 62 850 beschrieben, mittels NMR Spektren bestimmt. Die Glasübergangstemperatur der erfindungsgemäßen Polymere beträgt höchstens 20°C, bevorzugt -20 - +10°C. Die Peaktemperatur einer primären Dispersion von tan ∂ beträgt höchstens 30°C, bevorzugt -10 - +25°C, und wird, wie in der EP-B 0 0362 850 beschrieben, mittels visko-elastischen Bestimmungen mit einem Rheovibron® Gerät der Firma Orientec Corp. ermittelt. Der Polystyrolgehalt der erfindungswesentlichen Polymere beträgt 10 bis 30 Gew.-%, bevorzugt 15 - 25 Gew.-%. Das mittlere Molekulargewicht Mₙ dieser Polymere beträgt 30000 bis 280000, bevorzugt 60000 - 220000. Das mittlere Molekulargewicht Mₙ eines aromatischen Block beträgt 3000 bis 40000, das eines Vinylgruppen enthaltenden Elastomerblocks 10000 bis 200000.

Die erfindungswesentlichen Polymere werden bevorzugt als Mischungen mit anderen thermoplastisch elastomeren Blockcopolymeren, die einen Vinylbindungsgehalt ≤ 20% aufweisen, eingesetzt. Die Menge der erfindungswesentlichen Polymere beträgt in diesem Fall nicht weniger als 20 Gew.-% und nicht mehr als 55 Gew.-%, bevorzugt 50 Gew.-%, bezogen auf die Gesamtmenge der polymeren Bindemittel.

Besonders geeignet als weitere Blockcopolymere sind die in der DE-C 22 15 090; der US-A 4,320,188; der US-A 4,197,130; der US-A 4,430,417 oder der US-A 4, 162,919 beschriebenen.

Insbesondere lineare und radiale Blockcopolymere mit Polystyrolendblöcken wie z.B. Polystyrol-Polyisopren-Polystyrol, (Polystyrol-Polyisopren)₄Si oder die entsprechenden Butadienpolymere sind als Bindemittel geeignet, solange sie mit den erfindungswesentlichen Bindemitteln kompatibel sind. Besonders bevorzugt werden Polyisopren enthaltende Polymere verwendet. Das mittlere Molekulargewicht Mₙ der Blockcopolymere liegt üblicherweise zwischen 80 000 und 300 000, bevorzugt zwischen 100 000 und 250 000. Ein Anteil von Polystyrol von 10 - 40 Gew.-% ist vorteilhaft, vor allem ein Gehalt von 15 - 30 Gew.-%.

Die erfindungsgemäßen Polymere können in einer oder mehreren photopolymerisierbaren Schichten der Druckplatten verwendet werden. Ein besonderer Vorteil ist, daß keine zusätzlichen Druckschichten notwendig sind. Die Herstellung solcher photopolymerisierbarer Druckplatten ist somit einfach und kostengünstig.

Als ethylenisch ungesättigte Verbindungen in den photopolymerisierbaren Schichten werden die bekannten einfach oder mehrfach ungesättigten Monomere wie z.B. Ester oder Amide der Acrylsäure oder Methacrylsäure mit mono- oder polyfunktionellen Alkoholen, Aminen, Aminoalkoholen oder Hydroxyethern und -estern. Geeignet sind auch Mischungen aus mono- und polyungesättigten Verbindungen wie sie in der DE-C1 37 44 243 und der DE-A 36 30 474 beschrieben werden. Als Beispiele für die additionspolymersierbaren Verbindungen seien genannt: Butylacrylat, Isodecylacrylat, Tetradecylacrylat, 2-Hexyloxyethylacrylat, 1,4-Butandioldiacrylat, 1,6-Hexandioldimethacrylat, 1,6-Hexandioldiacrylat, Trimethylolpropantriacrylat und Dipentaerythritolmonohydroxypentacrylat.

Desweiteren enthalten die photopolymerisierbaren Schichten einen der bekannten Photoinitiatoren oder ein Photoinitiatorsystem, z.B. Methylbenzoin, Benzoinacetat, Benzophenon, Benzil-dimethyl-ketal, Ethylanthrachinon/4,4'-Bis-(dimethylamino)-benzophenon.

Die photopolymerisierbare Schicht enthält allgemein 60 - 80 Gew.-% Bindemittel oder Bindemittelgemisch, 5 - 30 Gew.-% Monomer oder Monomermischung und 0,5 - 5 Gew.-% Initiator. Die Menge der erfindungswesentlichen Blockcopolymere beträgt 10 - 45 Gew.-%, bevorzugt 20 - 45 Gew.-%. Bei höheren Gehalten der erfindungsgemäßen Polymere wird die Rückprallelastizität der Druckformen zu niedrig und andere Druckplatteneigenschaften wie die Kohäsion im Verbund bei Mehrschichtenplatten und die Adhäsion zur Trägerfolie werden negativ beeinflußt. Weitere Hilfsmittel wie z.B. Füllstoffe, Farbstoffe, Antioxidantien, Ozonschutzmittel, thermische Polymerisationsinhibitoren und Plastifizierungsmittel können in den üblichen Mengen enthalten sein.

Als Schichtträger für die erfindungsgemäßen photopolymerisierbaren Druckplatten eignen sich z.B. Folien aus den verschiedensten filmbildenden synthetischen Polymeren. Bevorzugt werden Polyester und Polyester-Polyamid-Folien, die ggf. mit einer Haftschicht und/oder einer Antihaloschicht versehen sein können, verwendet, insbesondere Polyethylenterephthaltfolien.

Als Deckschicht können die hierfür üblichen Folien aus z.B. Polystyrol, Polyethylen, Polypropylen oder Polyethylenterephthalat verwendet werden.

Unter der Deckschicht befindet sich ggf. eine dünne nicht klebende, mit dem Entwicklerlösungsmittel entfernbare Polymerschicht. Bevorzugt verwendet werden Polyamide, Copolymere aus Ethylen und Vinylacetat oder ähnliche Polymere, die transparente und reißfeste Filme bilden. Die Schichtdicke beträgt 0,0025 bis 0,038 mm.

Die Herstellung der photopolymerisierbaren Druckplatte erfolgt nach den üblichen Verfahren. Bevorzugt wird sie durch Extrudieren und anschließendes Kalandrieren der photopolymersierbaren Masse zwischen die Trägerschicht und ein Deckelement durchgeführt. Dieses Verfahren wird in der EP-B1 0 084 851 beschrieben. Das Deckelement kann lediglich aus einer Deckfolie bestehen oder zusätzlich noch aus einer elastomeren Schicht und/oder einer biegsamen Polymerschicht wie sie schon beschrieben wurden.

Die bildmäßige Belichtung der photopolymerisierbaren Druckplatte erfolgt nach allgemein üblichen Verfahren durch ein Negativ, wobei die Deckschicht der photopolymerisierbaren Druckplatte üblicherweise vor der bildmäßigen Belichtung entfernt wird.

Aktinische Strahlung beliebiger Herkunft und Art kann bei der Herstellung der flexographischen Druckformen benutzt werden. Geeignete Strahlungsquellen hierfür sind beispielsweise Quecksilberdampflampen, Glühlampen mit speziellen Leuchtstoffen, die Ultraviolettlicht emittieren, Argonglühlampen und Fotolampen. Am geeignetsten hiervon sind die Quecksilberdampflampen, insbesondere Ultraviolettlichtlampen und UV-Leuchtstofflampen.

Vor oder nach der bildmäßigen Belichtung kann eine vollflächige Rückseitenbelichtung durchgeführt werden. Diese Belichtung kann diffus oder gerichtet erfolgen. Als Belichtungsquellen können alle auch für die bildmäßige Belichtung üblichen Strahlungsquellen verwendet werden.

Das Auswaschen der nicht photopolymerisierten Bereiche der Druckplatte kann mit geeigneten Entwicklerlösungen, wie z. B. aliphatischen oder aromatischen Kohlenwasserstoffen wie n-Hexan, Petrolether, hydrierte Erdölfraktionen, Limonen oder anderen Terpenen oder Toluol, Isopropylbenzol, etc., Ketonen wie z.B.Methylethylketon, halogenierte Kohlenwasserstoffen wie Chloroform, Trichlorethan oder Tetrachlorethylen, Estern wie z.B. Essigsäure- oder Acetessigsäureester oder Gemischen der genannten Lösungsmittel, durchgeführt werden. Zusätze wie Tenside oder Alkohole sind möglich. Nach dem Trocknen können die so erhaltenen Druckformen zur Herstellung einer klebfreien Druckoberfläche in beliebiger Reihenfolge nachbelichtet und/oder chemisch nachbehandelt werden.

Die folgenden Beispiele sollen die vorliegende Erfindung verdeutlichen. Die angegebenen Teile und Prozente beziehen sich, falls nichts anderes angegeben ist, auf das Gewicht. Die mittleren Molekulargewichte der Polymere sind als Zahlenmittel Mₙ angegeben.

### Beispiel 1

In einem Laborkneter (Werner & Pfleiderer, Typ LUK 025) wurden jeweils 80 Gew.-% verschiedener Bindemittelgemische aus einem erfindungsgemäßen Block-Copolymeren, VS-3 Polymer der Fa. Kuraray, Japan, (Vinylbindungsgehalt 37%, Glastemperatur -17°C, Peaktemperatur von tan ∂ -3 °C, Polystyrolgehalt 20%), und einem handelsüblichen Block-Copolymeren, Cariflex 1107 der Fa. Shell, mit jeweils 8 Gew.-% Hexamethylenglykoldiacrylat, 1.8 Gew.-% Hexamethylenglykoldimethacrylat, 6 Gew.-% Nisso-PB B-1000, 3 Gew.-% Irgacure 651, 1 Gew.-% 2,6-Di-ter.-butyl-4-methylphenol und 0.2 Gew.-% eines handelsüblichen Farbstoffs bei ca. 145°C verknetet. Nach Abkühlen der Schmelzen wurden die Gemische zwischen zwei Polyesterfolien in einer Laborpresse (140°C, 23 bar) zu 2 mm starken Platten verpreßt. Diese Platten wurden anschließend in der für photopolymere Flexodruckplatten üblichen Weise verarbeitet (dh. belichtet, ausgewaschen und nachbelichtet). Aus Vollflächenbereichen wurden 3x3 cm große Stücke geschnitten und deren Gewicht, Schichtdicke und Shore A Härte bestimmt. Dann wurden die Proben für 24 Stunden mit UV-Farbe (Magenta der Fa. Hartmann) überschichtet, gesäubert und erneut vermessen. Die prozentuale Gewichtszunahme, die Schichtdickenzunahme und die Abnahme an Shore A Härte der jeweiligen Proben sind in der Tabelle 1 aufgeführt. Ebenfalls aufgeführt ist der Belichtungsspielraum der verschiedenen Plattengemische. Zur Bestimmung dieser Größe wird zunächst die Belichtungszeit bestimmt, die nötig ist, um alle Punkte eines 2% Punkt-Feldes im 48 L/cm Raster sicher zu verankern. Anschließend wird die Belichtungszeit bestimmt, bei der die Tiefe einer 0,8 mm breiten negativen Linie geringer als 0,1 mm wird. Die Differenz beider Belichtungszeiten wird als Belichtungsspielraum angegeben.

**Tabelle 1**

| | Verhältnis der Bindemittel | | %Gew.-zunahme | Dicken zunahme microns | Härteverlust Shore A | Belichtungsspielraum (min) |
|---|---|---|---|---|---|---|
| | VS-3 % | 1107 % | | | | |
| A) | 0 | 100 | 2,60 | 59 | 5 | 4 |
| B) | 21,5 | 78,5 | 2,31 | 60 | 4 | >7 |
| C) | 34,6 | 65,4 | 1,93 | 33 | 3 | >10 |
| D) | 50 | 50 | 1,68 | 20 | 4 | >7 |
| E) | 54 | 46 | 1,28 | 15 | 3 | >13 |

### Beispiel 2

Wie in Beispiel 1 beschrieben wurden Druckplatten hergestellt und verarbeitet. Als erfindungsgemäßes Bindemittel wurde diesmal ein VS-1 Polymer der Firma Kuraray, Japan, mit einem Vinylbindungsgehalt von 60%, einer Glastemperatur von 8°C, einer Peaktemperatur von tan ∂ von 20 °C und einem Polystyrolgehalt von 21% verwendet.

**Tabelle 2**

| | Verhältnis der Bindemittel | | %Gew.-zunahme | Dicken zunahme microns | Härteverlust Shore A | Belichtungsspielraum (min) |
|---|---|---|---|---|---|---|
| | VS-1 % | 1107 % | | | | |
| A) | 25 | 75 | 2,37 | 16 | 4,4 | >7 |
| B) | 50 | 50 | 1,62 | 16 | 3,0 | >7 |

## Patentansprüche

1. Photopolymerisierbares Gemisch enthaltend
a) mindestens ein elastomeres Bindemittel,
b) mindestens eine photopolymerisierbare, ethylenisch ungesättigte Verbindung,
c) mindestens einen Photoinitiator oder ein Photoinitiatorsystem,
**dadurch gekennzeichnet, daß**
es 10 - 45 Gew.-% mindestens eines thermoplastischen elastomeren Blockcopolymers zusammengesetzt aus zwei oder mehreren Polymerblöcken, bestehend aus aromatischen Vinyleinheiten, und einem oder mehreren Polymerblöcken, bestehend aus Isopren- und/oder Isopren/Butadien-Einheiten, mit einem Vinylbindungsgehalt von höchstens 70%, mit einer Glasübergangstemperatur von höchstens 20°C und mit einer Peak-Temperatur einer primären Dispersion von tan ∂ von höchstens 30°C, enthält.

2. Photopolymerisierbares Gemisch gemäß Anspruch 1,
**dadurch gekennzeichnet, daß**
der Vinylbindungsgehalt des thermoplastisch elastomeren Blockcopolymers höchstens 40% beträgt.

3. Photopolymerisierbares Gemisch gemäß Anspruch 1-2,
**dadurch gekennzeichnet, daß**
das thermoplastisch elastomere Blockcopolymer ein Polystyrol-Polyisopren-Polystyrol-Dreiblockcopolymer ist.

4. Photopolymerisierbares Gemisch gemäß Anspruch 1-3,
**dadurch gekennzeichnet, daß**
der Polystyrolgehalt des thermoplastisch elastomeren Blockcopolymeren 10-30 Gew.-% beträgt.

5. Photopolymerisierbares Gemisch gemäß Anspruch 1-4,
**dadurch gekennzeichnet, daß**
die Glasübergangstemperatur des thermoplastisch elastomeren Blockcopolymers höchstens 0°C beträgt.

6. Photopolymerisierbares Gemisch gemäß Anspruch 1-5,
**dadurch gekennzeichnet, daß**
als weiteres Bindemittel ein Polystyrol-Polyisopren-Polystyrol Blockcopolymer mit einem Vinylbindungsgehalt ≤ 20% verwendet wird.

7. Photopolymerisierbares Gemisch gemäß Anspruch 1-6,
**dadurch gekennzeichnet, daß**
die Menge des thermoplastisch elastomeren Blockcopolymeren gemäß Anspruch 1-5 20 - 55 Gew.-% bezogen auf die Gesamtmenge der polymeren Bindemittel beträgt.

8. Photopolymerisierbare Druckplatte umfassend einen Schichtträger, mindestens eine photopolymerisierbare Schicht und ein Deckelement,
**dadurch gekennzeichnet, daß**
die photopolymerisierbare Schicht aus einem photopolymerisierbaren Gemisch gemäß Anspruch 1-7 besteht.

9. Photopolymerisierbare Druckplatte gemäß Anspruch 8,
**dadurch gekennzeichnet, daß**
zwischen der photopolymerisierbaren Schicht und dem Deckelement eine weitere polymere Schutzschicht vorhanden ist.

10. Flexographische Druckform herstellbar aus einer photopolymerisierbaren Druckplatte gemäß einem der Ansprüche 8 oder 9.

## Claims

1. Photopolymerizable mixture containing
a) at least one elastomeric binder,
b) at least one photopolymerizable, ethylenically unsaturated compound, and
c) at least one photoinitiator or a photoinitiator system,
**characterized in that**
it contains 10 - 45 % by weight of at least one thermoplastic, elastomeric, block copolymer, composed of two or more polymer blocks comprising aromatic vinyl units and one or more polymer blocks comprising isoprene and/or isoprene/butadiene units, having a vinyl bond content not above 70 %, a glass transition temperature not above 20 °C, and a peak temperature of a primary dispersion of tan δ not above 30 °C.

2. Photopolymerizable mixture according to claim 1
**characterized in that**,
the vinyl bond content of the thermoplastic, elastomeric, block copolymer is between 30 to 60 %.

3. Photopolymerizable mixture according to claim 1 to 2
**characterized in that**,
the thermoplastic, elastomeric, block copolymer is a polystyrene-polyisoprene-polystyrene triple-block copolymer.

4. Photopolymerizable mixture according to claim 1 to 3
**characterized in that**,
the polystyrene content of the thermoplastic, elastomeric, block copolymer is 10 - 30 % by weight.

5. Photopolymerizable mixture to claim 1 to 4
**characterized in that**,
the glass transition temperature of the thermoplastic, elastomeric, block copolymer is not above 0 °C.

6. Photopolymerizable mixture according to claim 1 to 5
**characterized in that**,
a polystyrene-polyisoprene-polystyrene block copolymer having a vinyl bond content ≤ 20 % is used as additional binder.

7. Photopolymerizable mixture according to claim 1 to 6
**characterized in that**,
the quantity of the thermoplastic, elastomeric, block copolymer according to claims 1 - 5 is 20 - 55 % by weight, relative to the total weight of the elastomeric binders.

8. Photopolymerizable printing plate comprising a support, at least one photopolymerizable layer, and a cover element
**characterized in that**,
the photopolymerizable layer consists of a photopolymerizable mixture according to claims 1 - 7.

9. Photopolymerizable printing plate according to claim 8
**characterized in that**,
an additional polymeric protective layer exists between the photopolymerizable layer and the cover element.

10. Flexographic printing form that can be prepared from a photopolymerizable printing plate according to claims 8 or 9.

## Revendications

1. Mélange photopolymérisable contenant
a) au moins un liant élastomère,
b) au moins un composé photopolymérisable, à insaturation éthylénique,
c) au moins un agent photoinitiateur ou un système d'agents photo initiateurs,
**caractérisé en ce qu'**il contient 10 - 45% en poids au moins d'un copolymère séquencé élastomère thermoplastique, composé de deux ou de plusieurs blocs de polymères, se composant d'unités vinyliques aromatiques et d'un ou de plusieurs blocs de polymères, se composant d'unités isoprène et/ou isoprène/butadiène, ayant une teneur en vinyle d'au plus 70%, ayant une température de transition vitreuse d'au plus 20°C et ayant une température pic d'une dispersion primaire de tan ∂ d'au plus 30°C.

2. Mélange photopolymérisable selon la revendication 1, **caractérisé en ce que** la teneur en liant vinylique du copolymère séquencé élastomère thermoplastique est de 30 - 60%.

3. Mélange photopolymérisable selon les revendications 1 - 2, **caractérisé en ce que** le copolymère séquencé élastomère thermoplastique est un copolymère à trois blocs polystyrène-polyisoprène-polystyrène.

4. Mélange photopolymérisable selon les revendications 1 - 3, **caractérisé en ce que** la teneur en polystyrène du copolymère séquencé élastomère thermoplastique est de 10 - 30% en poids.

5. Mélange photopolymérisable selon les revendications 1 - 4, **caractérisé en ce que** la température de transition vitreuse du copolymère séquencé élastomère thermoplastique est au plus de 0°C.

6. Mélange photopolymérisable selon la revendication 1 - 5, **caractérisé en ce que** l'on utilise, en tant que liant supplémentaire, un copolymère séquencé polystyrène-polyisoprène-polystyrène, ayant une teneur en composé vinylique ≤ 20%.

7. Mélange photopolymérisable selon les revendications 1 - 6, **caractérisé en ce que** la quantité du copolymère séquencé élastomère thermoplastique selon les revendications 1 - 5 est de 20 -55% en poids , par rapport à la quantité totale du liant polymère.

8. Plaque d'impression photopolymérisable comprenant un support de couche, au moins une couche photopolymérisable et un élément de finition, **caractérisé en ce que** la couche photopolymérisable se compose d'un mélange photopolymérisable selon les revendications 1 - 7.

9. Plaque d'impression photopolymérisable selon la revendication 8, **caractérisé en ce qu'**il existe, entre la couche photopolymërisable et l'élément de finition, une couche de protection polymère supplémentaire.

10. Forme d'impression flexographique que l'on peut fabriquer à partir d'une plaque d'impression photopolymérisable selon l'une des revendications 8 ou 9.
